# EUROPEAN PATENT SPECIFICATION

(11) **EP 4 320 389 B1**
(45) Date of publication and mention of the grant of the patent: **02.09.2026**
(21) Application number: 21936185.4
(22) Date of filing: 08.04.2021
(51) Int. Cl.: F24C 7/08, F24C 3/12, H03K 17/968, H03K 17/94

(54) **OVEN COMPRISING A ROTARY SWITCH WITH OPTICAL SENSOR**
GARGERÄT UMFASSEND EINEN DREHSCHALTER MIT OPTISCHEM SENSOR
FOUR DE CUISSON COMPRENANT UN COMMUTATEUR ROTATIF DOTÉ D'UN CAPTEUR OPTIQUE

(43) Date of publication of application: 14.02.2024
(73) Proprietor: Ferel Elektronik San. Ve Tic. A.S., Silivri/Istanbul (TR)
(72) Inventor: BILGIC, Hasan Bahadir, Silivri/Istanbul (TR); KUS, Emre, Silivri/Istanbul (TR)
(74) Representative: Soylu, Ekrem
(86) International application number: PCT/TR2021/050329
(87) International publication number: WO 2022/216243

(56) References cited:
- WO-A1-2013/041514
- WO-A1-2013/098063
- WO-A1-2018/188574
- CN-U- 204 189 066
- DE-A1- 3 705 010
- US-A- 3 946 225

## Description

### TECHNICAL FIELD

The invention relates to an oven comprising a rotary switch and particularly a rotary switch with an optical sensor, which is configured to operate mode selection.

### BACKGROUND OF THE ART

Cooking appliances, particularly the oven, various operation modes are selected by means of a rotary switch and the commands are transferred to the open or closed electronic control circuit, e.g. a processor, by encoding as an electronic signal pattern for the corresponding mode of operation. The rotary switch mounted to the shaft of the rotary knob initiates the operation of the functional elements e.g. top resistance, bottom resistance, fan in accordance with the predetermined operation mode of the indicated angular position by rotating the rotary knob to the selected station. The rotary switch usually consists of a universal coding contact disc and a wiper that sweep the disc radially from its center to outer periphery.

EP0805467B1 discloses a switch provides an coded output signal pattern characteristic of each switch position, by providing different connections between a contact slider and coded contact paths of a universal coding contact disc for each switch position. Pref. the contact slider is fitted directly to the rotary setting shaft of the switch, with the coded contact paths arranged coaxial to the setting shaft, with non-linearly distributed coding positions around the periphery of the coding contact disc. Further prior art is known from DE3705010A1 and

US3946225A.

### BRIEF DESCRIPTION OF THE INVENTION

The invention is defined by claim 1. The object of the invention is to provide an oven comprising a hollow rotary switch that provides many different switch variants for a cooking device.

In order to achieve the above objective, the invention relates to an oven comprising a rotary switch comprising a contact disc having a contact pattern mounted to a rotary knob such that rotates together and a sensor assembly engaging the contact pattern when rotary knob arrive to a predefined providing an electrical signal to a corresponding controller so that activating a selected cooking mode operational angular position in a cooking position. The contact disc is in the form of a ring surrounding an inner hole and is having a corresponding optical sensor adjusted to generate the electrical signal from a light beam provided from a light source aligned across the contact pattern in the cooking position. The ring form of the contact disc provides a convenient housing for mounting a display, in the inner hole delimited by the rotary switch. The contact pattern following a ring-shaped path of the contact disc, for example, pairs with a fixed optical sensor to obtain a rotary switch that performs the cooking mode selection function by the rotation of the contact disc. Preferably, the controller comprises an electronic circuit board and having a memory unit in which more than one cooking mode is stored. Thus, it is possible to select the corresponding different cooking mode for the successive operational angular positions of the rotary knob.

In a preferred embodiment of the invention, the optical sensor and the light source are located opposite each other on the contact disc and the contact pattern has a radially distributed multiple opening across the contact disc. In this way, a compact sensor assembly is obtained by disposing the light source on one side of the contact disc and the optical sensor on the other. In a possible embodiment, the light source and the sensor assembly can be arranged side by side and electric signal generation can be achieved by reflecting the light back through the contact pattern.

In a preferred embodiment of the invention, the optical sensor is comprising a plurality of detection sections independent of each other, and each detection section is configured to detect the presence of the corresponding opening when the light beam hits. In this case, it is possible to embed a code with a bit value equal to the number of detection segments with the contact pattern on the contact disc and transmit it to the controller as an electrical signal. For example, with an optical sensor with five detecting sections, it is possible to universally encode five bits of data over the open and closed parts in the corresponding contact pattern. In this case, 2⁵ code data variant in the contact pattern can be transmitted to the controller. Simply by detecting the presence of electrical signal in the opening and closed part and the corresponding detecting sections, which are arranged to provide different codes on the ring, the information compared with the universal codes in the memory unit by the controller, the functional elements assigned in the cooker (for example, upper resistance, lower resistance, fan etc.) can be activated by the controller.

In a preferred embodiment of the invention, the optical sensor comprises at least two adjacent and sequential detecting sections. By adjacent the detecting sections, a compact sensor assembly is obtained to fit a rotary switch suitable for use at the command of the cooking device. Moreover, by arranging them sequentially on the ring-shaped contact disc, simultaneous alignment of each detection section with an opening or a closed part at the is ensured.

In a preferred embodiment of the invention, the inner hole of the contact disc is circular and coaxial with the track the radial contact pattern. In this way, when the rotary knob is rotated, the contact pattern moves in a circular path. This ensures exact alignment of the contact disc against the fixed sensor assembly at different angular positions.

In a preferred embodiment of the invention, the light source is having a LED element provided on the controller. The LED element can be easily mounted on the stationary controller.

In a preferred embodiment of the invention, the contact disc is connected to the controller in a way that transmits an electrical signal modulated with a predetermined coded key sequence when the contact disk reach to an operational angular position.

### BRIEF DESCRIPTION OF THE FIGURES

Figure 1 is a front view of a built-in oven equipped with a representative embodiment of the subject matter rotary switch.
Figure 2 is the front schematic illustration of a representative embodiment of the inventive rotary switch in a first cooking mode.
Figure 3 is the front schematic illustration of a representative embodiment of the inventive rotary switch in a second cooking mode.
Figure 4 is a cross-sectional view of the contact disc at a distance from the controller.

### DETAILED DESCRIPTION OF THE INVENTION

In this detailed explanation, the invention is explained without any limitation and only with reference to examples to better explain the subject matter.

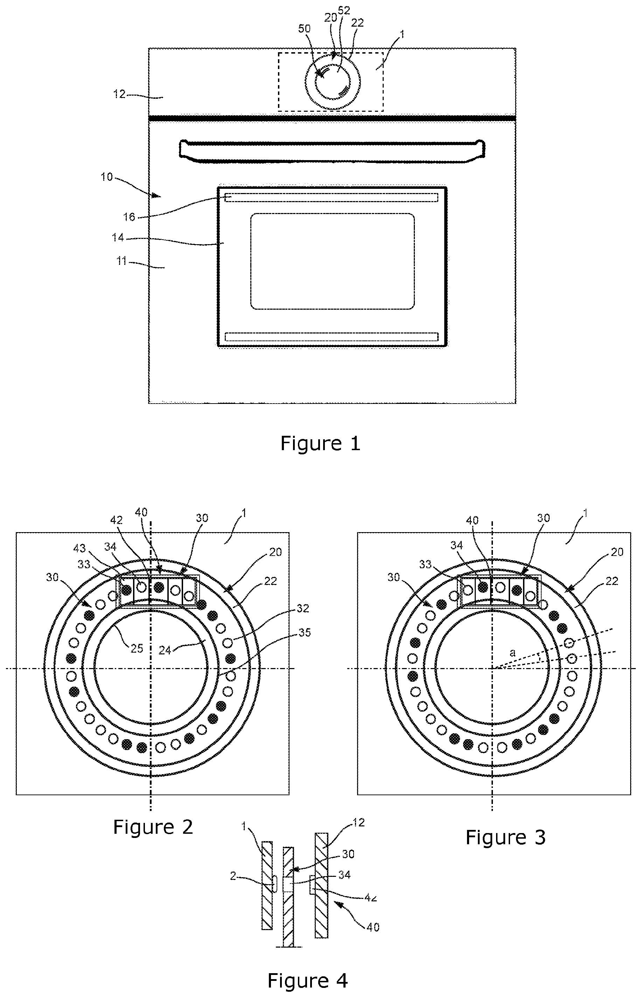

Figure 1 illustrates a domestic built-in oven from the front. The oven has a cooking chamber (14) surrounded by a closable casing (10) and accessible with a front cover (11) hinged to the casing (10). An electrical heating element (16) is electrically connected to a controller (1) such that activated in a cooking mode in the cooking chamber (14). A control panel (12) is provided in the form of a flat panel extending from one end to the other above the front cover (11). A rotary adjustment knob (20) is located in the middle of the control panel (12). The rotary knob (20) can rotate 360° on a shaft (not shown) extending vertically towards the rear of the control panel (12). The controller (1) is having an electronic printed circuit secured behind the control panel (12) in line with the rotary adjustment knob (20). The rotary adjustment knob (20) is in the form of a cylindrical container and can be grasped manually by the operator from an outer periphery (22). A display assembly (50) is mounted therein by providing a circular gap in the central part of the rotary adjustment knob (20). A circular screen (52) is provided at the front of the display assembly (50).

Figure 2 shows schematically a rotary switch from the front comprising a rotary knob (20) and a ring shape contact disc (30) adapted to the rotary adjustment knob (20) and a sensor assembly (40) secured thereon. The contact disc (30) is secured coaxially with the rotary knob (20) between the peripheral outer part (22) of the rotary knob (20) and an opposite inner part (24). In the inner part (24) a central gap (25) is confined, which secure the display assembly (50). A contact pattern (32) is formed on the contact disk (30) in alignment with a circular path coaxial with the center of the contact disc (30). The contact pattern (32) consists of radially distributed openings (34) that are uniform and spaced apart from each other and closed parts (33) between them. The opening (34) and the closed parts (33) are arranged in quintuple bits, sometimes adjacent to each other, sometimes separate, to form a code. The sensor assembly (40) includes an optical sensor (42) with detecting sections (43) adjacent to each other. The detection sections (43) are of five segmented construction, each aligned with an opening (34) or a closed parts (33) in the corresponding portion of the ring contact disc (30). In this way, at any radial position of the contact disk (30), the sensor assembly (40) reads five different bits of data. To achieve this, a light source (2) with an LED element is mounted on the controller (1), and the light source (2) illuminates the contact disc (30) from the inside, opposite the sensor assembly (40). The beam emerging from the light source (2) can only reach the detecting section (43) by passing through the corresponding opening (34).

On the other hand, the closed parts (33) mask the light source (2). Thus, the detection portion (43) aligned with the closed parts (33) does not generate any electrical signals. The light passing through the opening (34) generates an electrical signal in the sensor assembly (40) and transmits it to the controller (1) to which it is connected by cable (not shown).

The inner hole (35) of the contact disc (30) is adjacent to the inner part (24) of the coaxial rotary adjustment knob (20). The inner hole (35) of the contact disc (30) does not block the gap (25). Thus, the display assembly (50) can be inserted into the gap (25) by being pushed from the outside.

Figure 3 shows a new position where the arrangement of the contact pattern (32) is changed by moving the rotary adjustment knob (20) to the operational angular position (a). The alignment differs at each operational angular position (a) change. In this way, at each operational angular position (a) change, the sensor assembly (40) produces a unique data that does not repeat, as the contact pattern (32) hitting against it and the light coming from the light source (2) are masked in a different pattern. This data is transmitted to the controller (1) as an electrical signal. In this case, the reciprocal position of the contact disc (30) with the sensor assembly (40) is shown schematically from the side of the sensor assembly (40) in a representative embodiment in Figure 4. The light source (2) is integrated on the printed board of the controller (1). The sensor assembly (40) is located internally in the control panel (12). The optical sensor (42) is orthagonal to the light source (2) when the opening (34) in the contact pattern (32) is aligned radially. Thus, a compact structure is provided by adjusting the light source (2) adjacent to the contact disc (30).

By means of a processor and memory module (not shown) on the electronic circuit board, the controller (1) compares the data supplied from the sensor assembly (40) with the predetermined cooking mode configurations and determines the selected cooking mode by rotating the rotary knob (20). Accordingly, the cooking operation in the cooking chamber (14) is initiated by activating the electrical heating element (16) to energize. The direction of rotation is determined with a starting point defined as the reference and compared with the modulation obtained according to the striking contact pattern (32) detected by the sensor assembly (40) as described above. Therefore, with the one rotary adjustment knob (20), the rotary switch will set both the cooking mode, and also the temperature. A time information is displayed on the screen (52) by detecting the reference shut-off information of the oven by means of the controller (1) as shown in Figure 1. By grasping and rotating the rotary adjustment knob (20) from the outer peripheral part by the user (22) the contact disc (30) is rotated and provides radial displacement of the part opposite the sensor assembly (40), which is secured in the housing (10). The optical sensor (42) is activated by the controller (1) and controls which of the detecting parts (43) has voltage during the rotation. The detecting sections (43) corresponding to the openings (34) hits the light beam originated from the light source (2) and generate generates voltage to be transmitted to the controller (1). The controller (1) transmits the corresponding cooking mode to the display device (50) as an electrical signal, according to the selected 5 bit code, and ensures that the cooking mode information is displayed on the screen (52). When the user observe the cooking mode he wishes to select on the display (52), he select a new operational angular position (a). Thus, the controller (1) switches to a temperature setting mode. Display (52) shows the minimum temperature for the selected cooking mode. The user again rotates the rotary knob (20) clockwise or counterclockwise to increase and decrease the temperature setting, respectively. This process determines the direction in which the rotary adjustment knob (20) moves by taking the selected code of the sensor assembly (40) as reference, by comparing it with the operational angular position (a) from the memory module of the controller (1), increasing or decreasing the temperature accordingly. When the selection is complete, the controller (1) continues to drive the thermostat (not shown) so that the temperature of the cooking chamber (14) is heated to the value closest to the selected value. In addition, it turn on the relevant functional element, for example the electrical heating element (16), according to the selected cooking mode. The cooking time selection on the oven or the setting of other parameters (for example, alarm) can also be performed by rotating the rotary adjustment knob (20), similar to the above description.

### REFERENCE NUMBERS

| | | | |
|---|---|---|---|
| 1 | Controller | 30 | Contact disc |
| 2 | Light source | 32 | Contact pattern |
| 10 | Casing | 33 | Closed part |
| 11 | Front cover | 34 | Opening |
| 12 | Control panel | 35 | Inner hole |
| 14 | Cooking room | 40 | Sensor assembly |
| 16 | Electric heating element | 42 | Optical sensor |
| 20 | Rotary knob | 43 | Detection section |
| 22 | Outer periphery | 50 | Display assembly |
| 24 | Inner side | 52 | Display |
| 25 | Gap | a | Operational angular position |

## Claims

1. An oven comprising a rotary switch comprising a rotary knob (20) having a contact disc (30) with a contact pattern (32) mounted to the rotary knob (20) to rotate together; a sensor assembly (40) having an corresponding optical sensor (42) adjusted to generate the electrical signal from a light beam provided from a light source (2) aligned across the contact pattern (32) when rotary knob (20) arrive to a predefined operational angular position (a) in a cooking mode providing an electrical signal to a corresponding controller (1) to activate a selected cooking mode **characterized in that** the contact disc (30) having a ring shape and an inner hole (35); the contact disc (30) being secured coaxially with the rotary knob (20) between a peripheral outer part (22) of the rotary knob (20) and an opposite inner part (24); the inner part (24) providing a circular central gap (25), wherein the inner hole (35) does not block the circular gap (25); the rotary switch further comprises a display assembly (50) being mounted in the circular gap (25) in the central part of the rotary adjustment knob (20).

2. An oven according to claim 1, wherein the optical sensor (42) and the light source (2) are located opposite each other on the contact disc (30) and the contact pattern (32) has a radially distributed multiple opening (34) across the contact disc (32).

3. An oven according to claim 2, wherein the optical sensor (42) is comprising a plurality of detection sections (43) independent of each other and each detection section (43) is configured to detect the presence of the corresponding opening (34) when the light beam hits.

4. A rotary switch in accordance with claim 3, wherein the optical sensor (42) is having at least two adjacent and sequential detection sections (43).

5. An oven according to any one of the preceding claims, wherein the inner hole (35) of the contact disc (30) is circular and coaxial with the track the radial contact pattern (32).

6. An oven according to any one of the preceding claims, wherein the light source (2) is having an LED element provided on the controller (1).

7. An oven according to claim 6, wherein the contact disc (30) is connected to the controller (1) in a way that transmits an electrical signal modulated with a predetermined coded key sequence when the contact disk (30) reach to an operational angular position (a).

## Patentansprüche

1. Backofen, umfassend einen Drehschalter, der einen Drehknopf (20) umfasst, welcher eine Kontaktscheibe (30) mit einem Kontaktmuster (32) aufweist, die an dem Drehknopf (20) montiert ist, um sich gemeinsam zu drehen; eine Sensoranordnung (40), die einen entsprechenden optischen Sensor (42) aufweist, der dazu eingerichtet ist, das elektrische Signal aus einem Lichtstrahl zu erzeugen, der von einer Lichtquelle (2) bereitgestellt wird, welche gegenüber dem Kontaktmuster (32) ausgerichtet ist, wenn der Drehknopf (20) in einem Garmodus eine vordefinierte betriebsmäßige Winkelposition (a) erreicht, wobei ein elektrisches Signal an eine entsprechende Steuerung (1) geliefert wird, um einen ausgewählten Garmodus zu aktivieren, **dadurch gekennzeichnet, dass** die Kontaktscheibe (30) eine Ringform und ein Innenloch (35) aufweist; die Kontaktscheibe (30) koaxial mit dem Drehknopf (20) zwischen einem äußeren Umfangsteil (22) des Drehknopfes (20) und einem gegenüberliegenden Innenteil (24) befestigt ist; der Innenteil (24) eine kreisförmige zentrale Aussparung (25) bereitstellt, wobei das Innenloch (35) die kreisförmige Aussparung (25) nicht blockiert; der Drehschalter ferner eine Anzeigeanordnung (50) umfasst, die in der kreisförmigen Aussparung (25) im zentralen Teil des Dreheinstellknopfes (20) montiert ist.

2. Backofen nach Anspruch 1, wobei der optische Sensor (42) und die Lichtquelle (2) einander gegenüberliegend an der Kontaktscheibe (30) angeordnet sind und das Kontaktmuster (32) mehrere radial verteilte Öffnungen (34) über die Kontaktscheibe (32) hinweg aufweist.

3. Backofen nach Anspruch 2, wobei der optische Sensor (42) eine Mehrzahl von voneinander unabhängigen Erfassungsabschnitten (43) umfasst und jeder Erfassungsabschnitt (43) dazu ausgebildet ist, das Vorhandensein der entsprechenden Öffnung (34) zu erfassen, wenn der Lichtstrahl auftrifft.

4. Drehschalter nach Anspruch 3, wobei der optische Sensor (42) mindestens zwei benachbarte und aufeinanderfolgende Erfassungsabschnitte (43) aufweist.

5. Backofen nach einem der vorhergehenden Ansprüche, wobei das Innenloch (35) der Kontaktscheibe (30) kreisförmig und koaxial mit der Bahn des radialen Kontaktmusters (32) ist.

6. Backofen nach einem der vorhergehenden Ansprüche, wobei die Lichtquelle (2) ein an der Steuerung (1) vorgesehenes LED-Element aufweist.

7. Backofen nach Anspruch 6, wobei die Kontaktscheibe (30) derart mit der Steuerung (1) verbunden ist, dass sie ein mit einer vorbestimmten codierten Schlüsselsequenz moduliertes elektrisches Signal überträgt, wenn die Kontaktscheibe (30) eine betriebsmäßige Winkelposition (a) erreicht.

## Revendications

1. Four comprenant un commutateur rotatif comprenant un bouton rotatif (20) présentant un disque de contact (30) avec un motif de contact (32), monté sur le bouton rotatif (20) afin de tourner conjointement ; un ensemble capteur (40) présentant un capteur optique correspondant (42) adapté pour générer le signal électrique à partir d'un faisceau lumineux fourni par une source lumineuse (2) alignée en face du motif de contact (32) lorsque le bouton rotatif (20) atteint une position angulaire opérationnelle prédéfinie (a) dans un mode de cuisson, fournissant un signal électrique à un dispositif de commande correspondant (1) pour activer un mode de cuisson sélectionné, **caractérisé en ce que** le disque de contact (30) présente une forme annulaire et un trou intérieur (35) ; le disque de contact (30) étant fixé coaxialement avec le bouton rotatif (20) entre une partie extérieure périphérique (22) du bouton rotatif (20) et une partie intérieure opposée (24) ; la partie intérieure (24) ménageant un évidement central circulaire (25), dans lequel le trou intérieur (35) n'obstrue pas l'évidement circulaire (25) ; le commutateur rotatif comprenant en outre un ensemble d'affichage (50) monté dans l'évidement circulaire (25) dans la partie centrale du bouton de réglage rotatif (20).

2. Four selon la revendication 1, dans lequel le capteur optique (42) et la source lumineuse (2) sont situés à l'opposé l'un de l'autre sur le disque de contact (30) et le motif de contact (32) présente de multiples ouvertures (34) réparties radialement sur le disque de contact (32).

3. Four selon la revendication 2, dans lequel le capteur optique (42) comprend une pluralité de sections de détection (43) indépendantes les unes des autres et chaque section de détection (43) est configurée pour détecter la présence de l'ouverture correspondante (34) lorsque le faisceau lumineux frappe.

4. Commutateur rotatif selon la revendication 3, dans lequel le capteur optique (42) présente au moins deux sections de détection (43) adjacentes et séquentielles.

5. Four selon l'une quelconque des revendications précédentes, dans lequel le trou intérieur (35) du disque de contact (30) est circulaire et coaxial avec la piste du motif de contact radial (32).

6. Four selon l'une quelconque des revendications précédentes, dans lequel la source lumineuse (2) présente un élément LED prévu sur le dispositif de commande (1).

7. Four selon la revendication 6, dans lequel le disque de contact (30) est relié au dispositif de commande (1) de manière à transmettre un signal électrique modulé avec une séquence de clé codée prédéterminée lorsque le disque de contact (30) atteint une position angulaire opérationnelle (a).
